# EUROPÄISCHE PATENTSCHRIFT

(11) **EP 2 884 290 B1**
(45) Veröffentlichungstag und Bekanntmachung des Hinweises auf die Patenterteilung: **30.10.2019**
(21) Anmeldenummer: 14194000.7
(22) Anmeldetag: 20.11.2014
(51) Int. Cl.: G01R 27/18

(54) **Vorrichtung und Verfahren zur Isolationsüberwachung in einem Stromversorgungssystem mit hochohmig geerdetem Sternpunkt**
Device and method for insulation monitoring in a power supply system having high ohmic grounded star point
Dispositif et procédé de surveillance de l'isolation dans un système d'alimentation en courant ayant un point neutre mis à la terre à haute impédance

(30) Priorität: 13.12.2013 DE 102013225946
(43) Veröffentlichungstag der Anmeldung: 17.06.2015
(73) Patentinhaber: Bender GmbH & Co. KG, 35305 Grünberg (DE)
(72) Erfinder: Hackl, Dieter, 35463 Fernwald (DE); Bröckmann, Eckhard, DE-35396 Gießen (DE); Macht, Burkhard, 35410 Hungen (DE)
(74) Vertreter: advotec.

(56) Entgegenhaltungen:
- WO-A1-2005/050229
- WO-A2-02/15355
- DE-A1- 3 003 902
- DE-A1- 19 837 933

## Beschreibung

Die Erfindung betrifft eine Vorrichtung und ein Verfahren zur Isolationsüberwachung in einem Stromversorgungssystem, welches aus einem Hauptsystem mit einem über einen Sternpunktwiderstand hochohmig geerdeten Sternpunkt und optional aus mindestens einem Subsystem besteht, wobei das Hauptsystem und das Subsystem jeweils eine Differenzstrommesseinrichtung zur Erfassung eines Differenzstroms aufweisen.

Um eine hohe Verfügbarkeit und Betriebssicherheit der elektrischen Stromversorgung sicherzustellen sowie die Personensicherheit im Aufenthaltsbereich elektrischer Anlagen zu gewährleisten, sind Stromversorgungsnetze verbreitet, deren aktive Teile im Gegensatz zu geerdeten Netzformen von dem Erdpotential getrennt sind. Bei dieser als ungeerdetes IT-System bezeichneten Art des Stromversorgungsnetzes kann ein aktiver Leiter einen Isolationsfehler aufweisen, ohne dass der laufende Betrieb der Anlage unterbrochen werden muss, weil sich wegen des im Idealfall unendlich großen Impedanzwertes zwischen Leiter und Erde in diesem ersten Fehlerfall kein geschlossener Stromkreis ausbilden kann.

Als Isolationsfehler wird dabei ein fehlerhafter Zustand des IT-Systems verstanden, der zum Absinken des Isolationswiderstands unter das zulässige Isolationsniveau führt.

Neben diesen ungeerdeten IT-Systemen existiert weltweit eine weitere Netzform, bei der ein Sternpunkt über eine ausreichend hohe Impedanz mit Erde verbunden ist. Diese Impedanz kann als ohmscher Widerstand ausgeführt und hoch- oder niederohmig ausgelegt sein. Im Falle der hier betrachteten hochohmigen Widerstandserdung - international auch als high resistance grounding (HRG) bezeichnet - begrenzt dieser Sternpunktwiderstand einen auftretenden Fehlerstrom auf einen Wert, der noch nicht zum Auslösen einer Überstrom-Schutzeinrichtung führt.

Häufig werden derartige HRG-Systeme so ausgelegt, dass der Fehlerstrom bei einem ersten Isolationsfehler auf Werte zwischen 5A und 10A begrenzt wird und das HRG-System erst abschaltet, wenn der Fehlerstrom über 10A ansteigt. Eine in vielen europäischen, geerdeten Stromversorgungssystemen aus Brandschutzgründen übliche Begrenzung des Fehlerstroms auf Werte von 300mA ist daher in einem HRG-System nicht möglich.

Ausgehend von einem auf 5A begrenzten Fehlerstrom entsteht in einem 600V-Drehstromnetz bei einem satten Erdschluss einer Phase gegen Erde an dem strombegrenzenden Widerstand des HRG-Systems eine Wirkleistung von ca. 1.8kW. Die Erkenntnis, dass eine Brandgefährdung bereits ab Wirkleistungswerten oberhalb 60W, also bei weitaus geringeren Fehlerströmen auf Grund hochohmiger Isolationsfehlerwiderstände wahrscheinlich wird, scheint offenbar von den Befürwortern und Betreibern von HRG-Systemen nicht ausreichend berücksichtigt worden zu sein.

Der Einsatz von bei IT-Systemen üblichen Isolationsüberwachungsgeräten, die in der Regel von einem idealerweise unendlich großen (Isolations-) Widerstand des IT-Systems gegen Erde ausgehen, ist auf Grund der im Vergleich zu einem IT-System allerdings relativ niederohmigen HRG-Verbindung mit Erde meist nicht möglich. Eine (geringe) Isolationsminderung, bei der ein hochohmiger Isolationsfehler mit einem demzufolge geringen Fehlerstrom verbleibt, ist somit nicht erkennbar. Eine Überwachung des Isolationszustandes eines HRG-Systems erfolgt vorwiegend über eine Differenzstrommessung an der Sternpunktverbindung. Als Nachteil erweist sich dabei, dass mit der zentralen Differenzstrommessung des Sternpunktstroms symmetrische Fehler, sich kompensierende Ableit- und Fehlerströme und über Erde fließende Querströme zwischen den aktiven Leitern ebenfalls nicht erkannt werden können.

Weiterhin zeigen Simulationsergebnisse für eine Fehlerkonstellationen in einem HRG-System mit einem kapazitiven Querstrom über Erde, dass bei einem Fehlerstrom von ca. 30A Spitzenwert durch den Isolationsfehler(-Widerstand), der messbare Differenzstrom über den Sternpunktwiderstand unter 5A Spitzenwert liegt. Obwohl also der Stromfluss in der Sternpunktverbindung begrenzt wird, können genau die gefährlichen Brände entstehen, die durch die Strombegrenzung im Sternpunkt eigentlich verhindert werden sollten.

Ähnlich wie in IT-Systemen muss auch bei HRG-Systemen bei einem ersten Isolationsfehler der Fehler lokalisiert und so schnell wie möglich beseitigt werden. Aus dem Stand der Technik sind bei der Fehlersuche in einem HRG-System Verfahren bekannt, bei denen einen Teil des Sternpunktwiderstandes gepulst und periodisch überbrückt wird. Der periodisch verringerte Sternpunktwiderstandswert führt zu einer gepulsten Erhöhung des Fehlerstromwertes im fehlerhaften Abgang des HRG-Systems. Dieser gepulste Fehlerstrom kann mittels einer Differenzstrommessung detektiert werden. Allerdings besitzt diese Methode zur Isolationsfehlersuche den Nachteil, dass sie als passives Verfahren nicht zur Überwachung symmetrischer Isolationsminderungen erweitert werden kann.

Aus der Offenlegungsschrift WO 2005/050229 A1 ist ein aktives Verfahren zur Bestimmung des Isolationswiderstands in einem geerdeten Wechselstromnetz bekannt, wobei ein weitgehend rechteckförmiges Gleichtakt-Messspannungssignal gegen Erde transformatorisch in das Wechselstromnetz eingespeist wird. Die Differenzstrom-Messsignalanteile sowie die Gleichtakt-Spannungssignale werden in allen Netzleitern an einer beliebigen Messstelle hinter der Einspeisestelle erfasst und zur Bestimmung des ohmschen Anteils des Isolationswiderstands ausgewertet.

Der vorliegenden Erfindung liegt die Aufgabe zu Grunde, eine Vorrichtung und ein Verfahren zur Isolationsüberwachung für ein HRG-Stromversorgungssystem vorzuschlagen, die auch hochohmige Isolationsfehlerwiderstände gegen Erde zuverlässig bestimmen und insbesondere bei symmetrischen Fehlern den Isolationswiderstand ermitteln können. Das zu entwickelnde System soll in bestehende HRG-Systeme integrierbar sein und zudem eine Isolationsfehlersuche in dem gesamten HRG-Stromversorgungssystem ermöglichen.

Diese Aufgabe wird bezogen auf eine Vorrichtung in Verbindung mit dem Oberbegriff des Anspruchs 1 gelöst durch einen Messsignalgenerator zur Erzeugung eines aktiven Messsignals und zur Einprägung des aktiven Messsignals in das Hauptsystem sowie durch eine Auswerteeinrichtung, die zur Auswertung von Differenzstrom-Messsignalen mit den Differenzstrommesseinrichtungen und mit dem Messsignalgenerator verbunden ist.

Der Grundgedanke der vorliegenden Erfindung beruht in vorteilhafterweise darauf, mit einem aktiven Messverfahren ein Messsignal in das optional verzweigte HRG-System einzuprägen und mittels einer Differenzstrommessung in den zu überwachenden Leitungsabgängen den durch das Messsignal getriebenen Fehlerstrom zu erfassen und zur Bestimmung des Gesamtisolationswiderstands des Stromversorgungssystems sowie zur Bestimmung der Teilisolationswiderstände des Hauptsystems und eventuell vorhandener Subsysteme heranzuziehen. Dazu weist die Isolationsüberwachungsvorrichtung einen Messsignalgenerator auf, der das auf das HRG-System zugeschnittene Messsignal erzeugt und am Einspeisepunkt des Hauptsystems in das Hauptsystem und eventuell vorhandene Subsysteme einprägt. Der von dem Messsignal getriebene Fehlerstrom wird von der Differenzstrommesseinrichtung in dem Hauptsystem sowie bei optional installierten Subsystemen von den verteilt angeordneten Differenzstrommesseinrichtungen in den Subsystemen erfasst und jeweils als (Differenzstrom-)Messsignal der Auswerteeinrichtung zugeführt.

Die Einspeisung des aktiven Messsignals ermöglicht die Erkennung von symmetrischen Isolationsfehlern, von sich kompensierenden Ableit- und Fehlerströmen und von über Erde fließenden Querströmen zwischen Leitern, wobei das Messsignal als Gleichtaktsignal die auftretenden Fehlerströme als messbare Differenzstromanteile über die aktiven Leiter des Stromversorgungssystems treibt.

Die erfindungsgemäße Isolationsüberwachungsvorrichtung ist somit in der Lage, vorbeugend auch in HRG-Systemen deutlich hochohmigere Isolationswiderstände und damit einhergehende Isolationsfehler zu bestimmen.

Zudem kann durch die Möglichkeit der Erkennung auch geringer Isolationsminderungen, d.h. bei Vorliegen von hochohmigen Isolationswiderständen mit kleinen Fehlerströmen, die oben angeführte 60W-Wirkleistungsgrenze in Fehlerwiderständen beachtet werden.

Das aktive Messsignal ist eine seriell zu dem Sternpunktwiderstand (18) eingeprägte Messspannung (Uₘₑₛₛ) oder ein parallel zu dem Sternpunktwiderstand (18) eingeprägter Messstrom.

Der Messsignalgenerator ist zur Einprägung der Messspannung als niederohmige Spannungsquelle ausgeführt, die mit dem Sternpunktwiderstand in Reihe geschaltet ist oder der Messsignalgenerator ist zur Einprägung des Messstroms als hochohmige Stromquelle ausgelegt und parallel zum Sternpunktwiderstand geschaltet.

Da der Sternpunktwiderstand in nahezu allen existierenden HRG-Systemen vorhanden ist, kann diese Gegebenheit vorteilhaft in technisch und wirtschaftlich einfacher Weise zur Einprägung des Messsignals genutzt werden. Der Sternpunktwiderstand stellt eine elektrisch und räumlich zentrale Stelle in dem HRG-System dar, so dass das zwischen dem Sternpunkt und Erde eingeprägte Messsignal als treibende Quelle für sämtliche Fehlerströme wirkt, die durch Isolationsfehler an beliebigen Stellen des Netzes auftreten. Bei Auftreten eines Isolationsfehlers schließt sich der Messkreis zwischen Netz und Erde über den Isolationsfehlerwiderstand und erzeugt einen als Differenzstrom von allen in diesem Stromkreis liegenden Differenzstrommesseinrichtungen erfassbaren Fehlerstrom.

Beide Varianten der aktiven Messsignaleinprägung weisen den Vorteil auf, dass der Wert des Sternpunktwiderstands unverändert bleibt, also keine gepulste Sternpunktwiderstandänderung erfolgt und dadurch auch die Strombegrenzung als eine spezifizierte Systemeigenschaft auf einem konstanten Wert verbleibt. Durch Auswertung der Beziehung von Messsignal und Differenzstrom ist eine deutlich bessere Auflösung auch bei hochohmigen Isolationsimpedanzen zu erzielen als durch Variation des Sternpunktwiders tands.

Weiterhin weist die Isolationsüberwachungsvorrichtung einen künstlichen Sternpunkt an den Außenleitern des Hauptsystems auf, über den ein Spannungssignal gegen Erde abgreifbar ist.

Durch Bildung des künstlichen Sternpunktes an den Außenleitern des Hauptsystems kann ein Spannungssignal gegen Erde gewonnen werden, welches in Verbindung mit den Differenzstrommessungen die Berechnung der Isolationswiderstände ermöglicht oder zur Regelung des Messsignals verwendet werden kann.

In weiterer Ausgestaltung weist der Messsignalgenerator eine Regeleinrichtung zur Regelung des erzeugten, aktiven Messsignals auf, wobei das im Hauptsystem erscheinende aktive Messsignal als das über den künstlichen Sternpunkt abgreifbare Spannungssignal zurückgeführt ist.

Die Regeleinrichtung stellt sicher, dass eine gezielte Einstellung eines oder mehrerer Messsignalparameter in dem Messsignalgenerator auch nach Durchlauf durch den Generator bzw. Transformator der Netzversorgung auf der Seite des Hauptnetzes korrekt erscheinen, um eine zuverlässige Erkennung des durch das Messsignal getriebenen Fehlerstroms zu gewährleisten. Dabei wird das eingeprägte, am Hauptsystem erscheinende Messsignal als Gleichtaktsignal an den Außenleitern des Hauptsystems abgegriffen und über einen künstlichen Sternpunkt in die Regeleinrichtung des Messsignalgenerators zurückgeführt.

In einer vereinfachten Schaltungsanordnung, insbesondere bei weniger komplexen Formen des Messsignals kann auch eine ständige Messung der Spannung an dem künstlichen Sternpunkt und die entsprechende Verrechnung dieses Spannungssignals in der Auswerteeinheit anstelle einer Regelung genügen.

In vorteilhafter Weise sind eine Signalform und Signalparameter des aktiven Messsignals an elektrische Kenngrößen des zu überwachenden Stromversorgungssystems anpassbar.

Um eine möglichst fehlerfreie Erfassung desjenigen Differenzstromanteils zu gewährleisten, der durch das eingeprägte Messsignal hervorgerufen wird, können die Signalform und die Signalparameter des Messsignals an die elektrischen Kenngrößen des HRG-Systems angepasst werden.

Insbesondere können so die charakteristischen Eigenschaften des HRG-Systems durch Berücksichtigung der Kenngrößen wie Belastbarkeit des Sternpunktwiderstandes, vorhandene Netzableitkapazitäten, bestehendes Isolationsniveau, Empfindlichkeit des HRG-Systems gegen Gleichtaktspannungen in die Auswertung miteinbezogen werden und bereits bei der Auswahl der Messsignalform und deren Parametrierung einfließen.

Weiterhin weist die Auswerteeinrichtung einen Datenspeicher zur Speicherung der Signalform und der Signalparameter des aktiven Messsignals sowie zur Speicherung der elektrischen Kenngrößen des Stromversorgungssystems auf.

Der Auswerteeinrichtung stehen damit im Hinblick auf eine schnelle und genaue Auswertung der erfassten Differenzströme Informationen über das eingeprägte Messsignal zur Verfügung.

In bevorzugter Ausgestaltung weist die Auswerteeinrichtung eine Recheneinheit zur Ausführung von digitalen Signalverarbeitungsalgorithmen auf, um aus den erfassten Differenzstrom-Messsignalen, den gespeicherten Signalparametern und den elektrischen Kenngrößen jeweils einen von dem aktiven Messsignal getriebenen Fehlerstromanteil zu extrahieren.

Auf der Grundlage der mit den verteilt angeordneten Differenzstrommesseinrichtungen erfassten Differenzströme und in Kenntnis der Signalparameter der eingeprägten Messspannung sowie der elektrischen Kenngrößen des Stromversorgungssystems werden in der Recheneinheit mit Methoden der digitalen Signalverarbeitung zunächst diejenigen Differenzstromanteile bestimmt, die von dem eingeprägten Messsignal getrieben werden.

Weiterhin ist in der Recheneinheit der Auswerteeinrichtung eine Verarbeitungsvorschrift zur Bestimmung des Gesamtisolationswiderstands des Stromversorgungssystems sowie optional zur Bestimmung der Teilisolationswiderstände des Hauptsystems und der Subsysteme auf Basis der extrahierten Fehlerstromanteile implementiert.

Ausgehend von den extrahierten Fehlerströmen ermittelt die Recheneinheit in einem weiteren Schritt den Gesamtisolationswiderstand des Stromversorgungssystems sowie die optional vorhandenen Teilisolationswiderstände des Hauptsystems und der Subsysteme.

In einer weiteren bevorzugten Ausgestaltung ist die Auswerteeinrichtung zur Isolationsfehlersuche für eine Lokalisierung eines Isolationsfehlers auf Basis der erfassten Differenzströme konfiguriert.

Die Isolationsüberwachungsvorrichtung kann durch Konfigurierung der Auswerteeinrichtung für die Isolationsfehlersuche erweitert werden. In diesem Fall wirkt der Signalgenerator als aktive Prüfstromquelle, die einen Prüfstrom über den Isolationsfehler(-Widerstand) treibt und der von den entsprechenden in diesem Prüfstromkreis liegenden Differenzstrommesseinrichtungen detektiert wird.

Mit Vorteil kann das Subsystem eine Auswerteeinrichtung aufweisen, die mit der Differenzstrommesseinrichtung dieses Subsystems zur autarken Auswertung des von der Differenzstrommesseinrichtung dieses Subsystems bereitgestellten Differenzstrom-Messsignals verbunden ist.

In dieser Ausgestaltung weist das Subsystem eine eigene Auswerteeinrichtung auf, die hinsichtlich der Auswertungsfunktionalität eine autarke Arbeitsweise des jeweiligen Subsystems ermöglicht.

Weiterhin kann das Subsystem zur Spannungsmessung gegen Erde einen künstlichen Sternpunkt aufweisen.

Insbesondere bei weit verzweigten Stromversorgungssystemen mit langen Zuleitungen zwischen den Systemen kann eine Spannungsmessung mittels eines künstlichen Sternpunkts am Eingang des Subsystems erforderlich sein, um das Subsystem in die Lage zu versetzen, phasenrichtig bzw. synchron zum Messsignalgenerator die Auswertung vornehmen zu können.

Bezogen auf ein Verfahren wird die der Erfindung zu Grunde liegende Aufgabe gelöst durch Erzeugen eines aktiven Messsignals und Einprägen des aktiven Messsignals in das Hauptsystem mit einem Messsignalgenerator und durch Auswerten von Differenzstrom-Messsignalen mit einer Auswerteeinrichtung, die mit den Differenzstrommesseinrichtungen und mit dem Messsignalgenerator verbunden ist.

Der Funktionsweise der vorbeschriebenen Vorrichtung zur Isolationsüberwachung liegt ein Verfahren zur Isolationsüberwachung zu Grunde, das als wesentliche Merkmale das Erzeugen und Einprägen eines aktiven Messsignals sowie das Auswerten der Differenzstrom-Messsignale mit einer Auswerteeinrichtung umfasst.

Erfindungsgemäß wird in dem Messsignalgenerator ein aktives Messsignal erzeugt und am Einspeisepunkt des Hauptsystems in das Hauptsystem und eventuell vorhandene Subsysteme einprägt. Das aktive Messsignal erlaubt im Gegensatz zu einer aus dem Stand der Technik bekannten gepulsten Überbrückung des Sternpunktwiderstandes eine Bestimmung der Isolationswiderstände bei symmetrischen Fehlern, bei sich kompensierenden Ableit- und Fehlerströmen und im Fall von über Erde fließenden Querströmen zwischen Leitern des Stromversorgungssystems.

Darüber hinaus lässt sich das aktive Messsignal an die elektrischen Eigenschaften des Stromversorgungssystems anpassen, so dass die von diesem Messsignal getriebenen Differenzstromanteile als Messströme im Isolationsüberwachungsbetrieb zuverlässig erfasst und von Störsignalen separiert werden können. Die durch die verteilt angeordneten Differenzstrommesswandler erfassten Differenzströme werden als Differenzstrom-Messsignale an die Auswerteeinrichtung weitergeleitet.

In technisch und wirtschaftlich einfach zu realisierender Weise wird das aktive Messsignal als Messspannung seriell zu dem Sternpunktwiderstand oder als Messstrom parallel zu dem Sternpunktwiderstand eingekoppelt.

Zweckmäßigerweise wird über einen künstlichen Sternpunkt von Außenleitern des Hauptsystems ein Spannungssignal gegen Erde abgegriffen.

Das abgreifbare Spannungssignal ermöglicht in Verbindung mit den Differenzstrommessungen die Berechnung der Isolationswiderstände oder kann zur Regelung des Messsignals herangezogen werden.

Weiterhin erfolgt eine Regelung des erzeugten, aktiven Messsignals, wobei das im Hauptsystem erscheinende aktive Messsignal als das über den künstlichen Sternpunkt abgreifbare Spannungssignal zurückgeführt wird.

Diese Messsignalregelung erlaubt unter Berücksichtigung der charakteristischen Eigenschaften des Netzes eine Einstellung der Signalparameter im Hinblick auf eine möglichst störungsfreie Erkennung der Differenzstromanteile.

In weiterer vorteilhafter Ausgestaltung erfolgt eine Anpassung von Signalform und von Signalparametern des aktiven Messsignals an elektrische Kenngrößen des zu überwachenden Stromversorgungssystems.

Mit dieser Maßnahme ist es möglich, die Signalparameter des aktiven Messsignals unter Berücksichtigung der elektrischen Eigenschaften des Stromversorgungsnetzes im Hinblick auf eine sicherere Erfassung der durch das Messsignal getriebenen Fehlerströme optimal einzustellen.

Weiterhin werden die Signalform und die Signalparameter des aktiven Messsignals und die elektrische Kenngrößen des Stromversorgungssystems in einem Datenspeicher der Auswerteeinrichtung gespeichert.

In Verbindung mit der Anwendung von digitalen Signalverarbeitungsverfahren ermöglicht die Verwendung der gespeicherten Information über das aktive Messsignal und über die elektrischen Eigenschaften des Stromversorgungssystems eine sichere Erkennung der der durch das aktive Messsignal getriebenen Differenzstromanteile.

In bevorzugter Ausführung des Verfahrens werden in einer Recheneinheit der Auswerteeinrichtung digitale Signalverarbeitungsalgorithmen ausgeführt, die aus den Differenzstrom-Messsignalen, den gespeicherten Signalparametern und den elektrischen Kenngrößen jeweils einen von dem aktiven Messsignal getriebenen Fehlerstromanteil extrahieren.

In einem weiteren Schritt erfolgt in der Recheneinheit der Auswerteeinrichtung eine Bestimmung des Gesamtisolationswiderstands des Stromversorgungssystems sowie optional eine Bestimmung der Teilisolationswiderstände des Hauptsystems und der Subsysteme auf Basis der extrahierten Fehlerstromanteile.

Aus den von den Differenzstrommesseinrichtungen an die Auswerteeinheit weitergeleiteten Differenzstrom-Messsignalen werden zunächst die jeweiligen durch das eingeprägte Messsignal hervorgerufenen Fehlerstromanteile mit Verfahren der digitalen Signalverarbeitung herausgefiltert. Aus diesen können dann der Gesamtisolationswiderstand des Stromversorgungssystems sowie optional die Teilisolationswiderstände des Hauptsystems und der Subsysteme bestimmt werden.

Weiterhin erfolgt zur Isolationsfehlersuche in der Auswerteeinrichtung eine Lokalisierung eines Isolationsfehlers auf Basis der erfassten Differenzströme.

Das Verfahren zur Isolationsüberwachung kann dahingehend erweitert werden, dass bei Erkennung eines Isolationsfehlers in der Auswerteeinrichtung eine Isolationsfehlersuche gestartet wird.

Mittels einer Auswerteeinrichtung in dem Subsystem erfolgt weiterhin eine autarke Auswertung des von der Differenzstrommesseinrichtung dieses Subsystems bereitgestellten Differenzstrom-Messsignals.

Mit dieser Ausgestaltung des Verfahrens ist in dem betreffenden Subsystem eine eigenständig Auswertung im Hinblick auf die Bestimmung des (Teil-)Isolationswiderstandes durchführbar.

Zweckmäßigerweise kann auch in dem Subsystem über einen künstlichen Sternpunkt eine Spannungsmessung gegen Erde erfolgen.

Insbesondere bei großen Leitungslängen kann eine Spannungsmessung in dem Subsystem erforderlich sein, um die phasensynchrone Auswertung zu dem Messsignal sicherzustellen.

Weitere vorteilhafte Ausgestaltungsmerkmale ergeben sich aus der nachfolgenden Beschreibung und der Zeichnung, die eine bevorzugte Ausführungsform der Erfindung anhand eines Beispiels erläutert. Es zeigt:

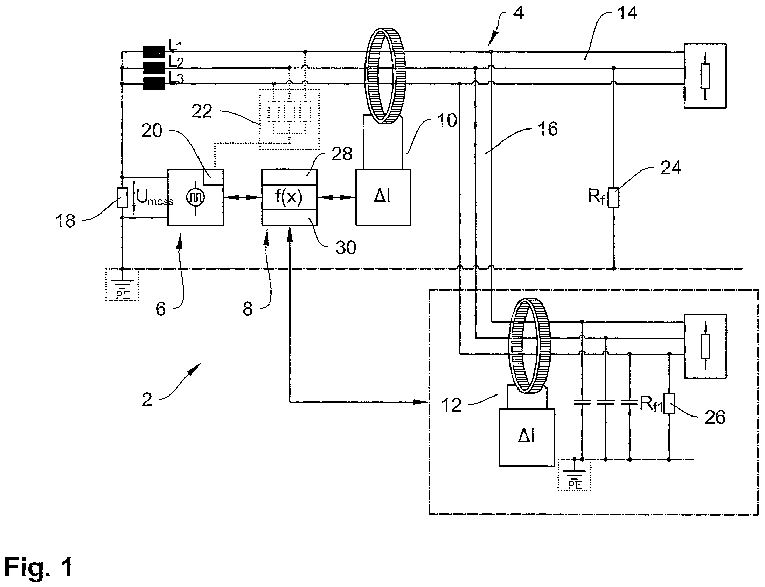

- **Fig. 1:**: eine erfindungsgemäße Vorrichtung 2 zur Isolationsüberwachung und zur Isolationsfehlersuche in einem verzweigten Stromversorgungssystem 4.

Die in **Fig. 1** dargestellte erfindungsgemäße Vorrichtung 2 zur Isolationsüberwachung und zur Isolationsfehlersuche umfasst als wesentliche funktionale Blöcke einen Messsignalgenerator 6, eine Auswerteeinrichtung 8 sowie zwei Differenzstrommesseinrichtungen 10 und 12. Die Vorrichtung 2 ist in ein verzweigtes, 3-phasige Stromversorgungssystem 4 (HRG-System) integriert, welches in diesem Ausführungsbeispiel aus einem Hauptsystem 14 und einem Subsystem 16 besteht. Ein Sternpunkt des Hauptsystems 14 ist über einen Sternpunktwiderstand 18 mit Erde PE verbunden.

Der Messsignalgenerator 6 erzeugt eine Messspannung Uₘₑₛₛ und prägt diese als Spannungsabfall über den Sternpunktwiderstand 18 in das Stromversorgungssystem 4 ein. Der Messsignalgenerator 6 der erfindungsgemäßen Vorrichtung 2 kann optional eine Regeleinrichtung 20 zur Einstellung der Messspannung Uₘₑₛₛ aufweisen, wobei als Eingangssignal der Regeleinrichtung 20 ein an Außenleitern L1, L2, L3 des Hauptsystems 14 abgegriffenes und über einen künstlichen Sternpunkt 22 der Regeleinrichtung 20 zugeführtes Spannungssignal in Form eines Gleichtaktsignal dient.

In dem vorliegenden Beispiel weist sowohl das Hauptsystem 14 als auch das Subsystem 16 jeweils einen Isolationsfehler 24, 26 auf, der durch den Isolationsfehlerwiderstand R_{f} dargestellt ist. Der Isolationsfehler 24 in dem Hauptsystem 14 führt zu einem von der Messspannung Uₘₑₛₛ getriebenen Fehlerstrom, der über den Außenleiter L2 des Hauptsystems 14 fließt, wohingegen der durch den Isolationsfehler 26 des Subsystems verursachte Fehlerstrom außer über den Außenleiter L1 des Hauptsystems 14 und zusätzlich über den Außenleiter L1 des Subsystems 16 fließt. Der von der Differenzstrommesseinrichtung 10 in dem Hauptsystem erfasste, von der Messspannung getriebene, Fehlerstromanteil wird hierbei durch den Gesamtisolationswiderstand des HRG-Systems 4 bestimmt. Der von der Differenzstrommesseinrichtung 12 in dem Subsystem 16 erfasste, von der Messspannung getriebene, Fehlerstromanteil wird durch den (Teil-) Isolationswiderstand des Subsystems des HRG-Systems 4 bestimmt. Die Differenzstrommesseinrichtungen 10, 12 leiten die erfassten Differenzströme als Differenzstrom-Messsignale an die Auswerteeinrichtung 8 weiter. Eine Recheneinheit 30 der Auswerteeinheit 8 extrahiert mit Hilfe der in einem Datenspeicher 28 gespeicherten Signalparameter der Messspannung Uₘₑₛₛ und der elektrischen Kenngrößen des Stromversorgungssystems 4 die von der Messspannung Uₘₑₛₛ getriebenen Fehlerstromanteile und zieht diese zur Bestimmung des Gesamtisolationswiderstands des Stromversorgungssystems 4 sowie des Teilisolationswiderstands des Subsystems 16 heran.

Neben der Bestimmung der Isolationswiderstände kann die erfindungsgemäße Vorrichtung auch zur Isolationsfehlersuche eingesetzt werden, da die Zuordnungen der Differenzstrommesseinrichtungen 10, 12 zu den Leitungsabgängen (hier Hauptsystem 14 und Subsystem 16) bekannt sind.

Die erfindungsgemäße Vorrichtung 2 zur Isolationsüberwachung lässt sich in einfacher Weise in bestehende HRG-Systeme 4 integrieren, da diese bereits mit Differenzstrommesseinrichtungen 10, 12 ausgerüstet sind und auf Grund der Einprägung des Messspannung über dem Sternpunktwiderstand 18 keine Unterbrechung der Sternpunktverbindung notwendig ist.

## Patentansprüche

1. Vorrichtung (2) zur Isolationsüberwachung in einem Stromversorgungssystem (4), welches aus einem Hauptsystem (14) mit einem über einen Sternpunktwiderstand (18) hochohmig geerdeten Sternpunkt oder aus dem Hauptsystem (14) mit dem über den Sternpunktwiderstand (18) hochohmig geerdeten Sternpunkt und mit mindestens einem Subsystem (16) besteht, wobei das Hauptsystem (14) und das vorhandene Subsystem (16) jeweils eine Differenzstrommesseinrichtung (10, 12) zur Erfassung eines Differenzstroms aufweisen,
die Vorrichtung aufweisend: einen Messsignalgenerator (6) zur Erzeugung eines aktiven Messsignals und zur Einprägung des aktiven Messsignals in das Stromversorgungssystem (4) sowie durch eine Auswerteeinrichtung (8), die zur Auswertung von Differenzstrom-Messsignalen mit den Differenzstrommesseinrichtungen (10, 12) und mit dem Messsignalgenerator (6) verbunden ist, wobei das aktive Messsignal eine seriell zu dem Sternpunktwiderstand (18) niederohmig als Spannungsabfall eingeprägte Messspannung (Uₘₑₛₛ) oder ein parallel zu dem Sternpunktwiderstand (18) eingeprägter Messstrom ist.

2. Vorrichtung (2) zur Isolationsüberwachung nach einem der Ansprüche 1 bis 3,
**gekennzeichnet durch**
einen künstlichen Sternpunkt (22) an den Außenleitern (L1, L2, L3) des Hauptsystems (14), über den ein Spannungssignal gegen Erde abgreifbar ist.

3. Vorrichtung (2) zur Isolationsüberwachung nach einem der Ansprüche 1 bis 3,
**dadurch gekennzeichnet,**
**dass** der Messsignalgenerator (6) eine Regeleinrichtung (20) zur Regelung des erzeugten, aktiven Messsignals aufweist, wobei das im Hauptsystem (14) erscheinende aktive Messsignal als das über den künstlichen Sternpunkt (22) abgreifbare Spannungssignal zurückgeführt ist.

4. Vorrichtung (2) zur Isolationsüberwachung nach einem der Ansprüche 1 bis 5,
**dadurch gekennzeichnet,**
**dass** eine Signalform und Signalparameter des aktiven Messsignals an elektrische Kenngrößen des zu überwachenden Stromversorgungssystems (4) anpassbar sind.

5. Vorrichtung (2) zur Isolationsüberwachung nach einem der Ansprüche 1 bis 6,
**dadurch gekennzeichnet,**
**dass** die Auswerteeinrichtung (8) einen Datenspeicher (28) zur Speicherung der Signalform und der Signalparameter des aktiven Messsignals sowie zur Speicherung der elektrischen Kenngrößen des Stromversorgungssystems (4) aufweist.

6. Vorrichtung (2) zur Isolationsüberwachung nach einem der Ansprüche 1 bis 7,
**dadurch gekennzeichnet,**
**dass** die Auswerteeinrichtung (8) eine Recheneinheit (30) zur Ausführung von digitalen Signalverarbeitungsalgorithmen aufweist, um aus den erfassten Differenzstrom-Messsignalen, den gespeicherten Signalparametern und den elektrischen Kenngrößen jeweils einen von dem aktiven Messsignal getriebenen Fehlerstromanteil zu extrahieren.

7. Vorrichtung (2) zur Isolationsüberwachung nach Anspruch -6,
**dadurch gekennzeichnet,**
**dass** in der Recheneinheit (30) der Auswerteeinrichtung (8) eine Verarbeitungsvorschrift zur Bestimmung des Gesamtisolationswiderstands des Stromversorgungssystems (4) sowie optional zur Bestimmung der Teilisolationswiderstände des Hauptsystems (14) und der Subsysteme (16) auf Basis der extrahierten Fehlerstromanteile implementiert ist.

8. Vorrichtung (2) zur Isolationsüberwachung nach einem der Ansprüche 1 bis 9,
**dadurch gekennzeichnet,**
**dass** zur Isolationsfehlersuche die Auswerteeinrichtung (8) für eine Lokalisierung eines Isolationsfehlers auf Basis der erfassten Differenzströme konfiguriert ist.

9. Vorrichtung (2) zur Isolationsüberwachung nach einem der Ansprüche 1 bis 10,
**dadurch gekennzeichnet,**
**dass** das Subsystem (16) eine Auswerteeinrichtung aufweist, die mit der Differenzstrommesseinrichtung (12) dieses Subsystems (16) zur autarken Auswertung des von der Differenzstrommesseinrichtung (12) dieses Subsystems (16) bereitgestellten Differenzstrom-Messsignals verbunden ist.

10. Vorrichtung (2) zur Isolationsüberwachung nach einem der Ansprüche 1 bis 11,
**dadurch gekennzeichnet,**
**dass** das Subsystem (16) zur Spannungsmessung gegen Erde (PE) einen künstlichen Sternpunkt (22) aufweist.

11. Verfahren zur Isolationsüberwachung in einem Stromversorgungssystem (4), welches aus einem Hauptsystem (14) mit einem über einen Sternpunktwiderstand (18) hochohmig geerdeten Sternpunkt oder aus dem Hauptsystem (14) mit dem über den Sternpunktwiderstand (18) hochohmig geerdeten Sternpunkt und mit mindestens einem Subsystem (16) besteht, wobei in dem Hauptsystem (14) und dem vorhandenen Subsystem (16) jeweils ein Differenzstrom mit einer Differenzstrommesseinrichtung (10, 12) erfasst wird,
das Verfahren bestehend aus folgenden Schritten: Erzeugen eines aktiven Messsignals und Einprägen des aktiven Messsignals in das Stromversorgungssystem (4) mit einem Messsignalgenerator (6) und Auswerten von Differenzstrom-Messsignalen mit einer Auswerteeinrichtung (8), die mit den Differenzstrommesseinrichtungen (10, 12) und mit dem Messsignalgenerator (6) verbunden ist, wobei als aktives Messsignal eine Messspannung (Uₘₑₛₛ) seriell zu dem Sternpunktwiderstand (18) niederohmig als Spannungsabfall oder ein Messstrom parallel zu dem Sternpunktwiderstand (18) eingekoppelt wird.

12. Verfahren zur Isolationsüberwachung nach einem der Ansprüche 13 bis 15,
**dadurch gekennzeichnet,**
**dass** über einen künstlichen Sternpunkt (22) von Außenleitern (L1, L2, L3) des Hauptsystems (14) ein Spannungssignal gegen Erde (PE) abgegriffen wird.

13. Verfahren zur Isolationsüberwachung nach einem der Ansprüche 13 bis 16,
**dadurch gekennzeichnet,**
**dass** eine Regelung des erzeugten, aktiven Messsignals erfolgt, wobei das im Hauptsystem (14) erscheinende aktive Messsignal als das über den künstlichen Sternpunkt (22) abgreifbare Spannungssignal zurückgeführt wird.

14. Verfahren zur Isolationsüberwachung nach einem der Ansprüche 13 bis 17,
**dadurch gekennzeichnet,**
**dass** eine Anpassung von Signalform und von Signalparametern des aktiven Messsignals an elektrische Kenngrößen des zu überwachenden Stromversorgungssystems (4) erfolgt.

15. Verfahren zur Isolationsüberwachung nach einem der Ansprüche 13 bis 18,
**dadurch gekennzeichnet,**
**dass** die Signalform und die Signalparameter des aktiven Messsignals und die elektrische Kenngrößen des Stromversorgungssystems (4) in einem Datenspeicher (28) der Auswerteeinrichtung (8) gespeichert werden.

16. Verfahren zur Isolationsüberwachung nach einem der Ansprüche 13 bis 19,
**dadurch gekennzeichnet,**
**dass** in einer Recheneinheit (30) der Auswerteeinrichtung (8) digitale Signalverarbeitungsalgorithmen ausgeführt werden, die aus den erfassten Differenzstrom-Messsignalen und den gespeicherten Signalparametern und den elektrischen Kenngrößen jeweils einen von dem aktiven Messsignal getriebenen Fehlerstromanteil extrahieren.

17. Verfahren zur Isolationsüberwachung nach Anspruch 20,
**dadurch gekennzeichnet,**
**dass** in der Recheneinheit (30) der Auswerteeinrichtung (8) eine Bestimmung des Gesamtisolationswiderstands des Stromversorgungssystems (4) sowie optional eine Bestimmung der Teilisolationswiderstände des Hauptsystems (14) und der Subsysteme (16) auf Basis der extrahierten Fehlerstromanteile erfolgt.

18. Verfahren zur Isolationsüberwachung nach einem der Ansprüche 13 bis 21,
**dadurch gekennzeichnet,**
**dass** zur Isolationsfehlersuche in der Auswerteeinrichtung (8) eine Lokalisierung eines Isolationsfehlers auf Basis der erfassten Differenzströme erfolgt.

19. Verfahren zur Isolationsüberwachung nach einem der Ansprüche 13 bis 22,
**dadurch gekennzeichnet,**
**dass** mittels einer Auswerteeinrichtung in dem Subsystem (16) eine autarke Auswertung des von der Differenzstrommesseinrichtung (12) dieses Subsystems (16) bereitgestellten Differenzstrom-Messsignals erfolgt.

20. Verfahren zur Isolationsüberwachung nach einem der Ansprüche 13 bis 23,
**dadurch gekennzeichnet,**
**dass** in dem Subsystem (16) über einen künstlichen Sternpunkt (22) eine Spannungsmessung gegen Erde (PE) erfolgt.

## Claims

1. A device (2) for insulation monitoring in a power supply system (4) that is composed of a main system (14) including a neutral point that is high-resistance grounded via a neutral-point resistance (18) or of the main system (14) including the neutral point that is high-resistance grounded via the neutral-point resistance (18) and at least one subsystem (16), the main system (14) and the subsystem (16) each having a differential current measuring device (10, 12) for registering a differential current,
the device having: a measuring signal generator (6) for generating an active measuring signal and for feeding the active measuring signal into the power supply system (4) and by an evaluating device (8) that is connected to the differential current measuring devices (10, 12) and to the measuring signal generator (6) to evaluate differential current measuring signals, the active measuring signal being a measuring voltage (Uₘₑₛₛ) that is fed serially to the neutral-point resistance (18) at low resistance as a voltage drop or a measuring current that is fed in parallel to the neutral-point resistance (18).

2. The device (2) for insulation monitoring according to any one of claims 1 to 3,
**characterized by**
an artificial neutral point (22) at the outer conductors (L1, L2, L3) of the main system (14), wherein a voltage signal can be tapped against ground via said artificial neutral point.

3. The device (2) for insulation monitoring according to any one of claims 1 to 3,
**characterized in that**
the measuring signal generator (6) has a control unit (20) for controlling the generated active measuring signal, wherein the active measuring signal appearing in the main system (14) is fed back as the voltage signal that can be tapped via the artificial neutral point (22).

4. The device (2) for insulation monitoring according to any one of claims 1 to 5,
**characterized in that**
a signal shape and signal parameters of the active measuring signal can be adapted to electrical characteristics of the power supply system (4) to be monitored.

5. The device (2) for insulation monitoring according to any one of claims 1 to 6,
**characterized in that**
the evaluating device (8) has a data memory (28) for storing the signal shape and the signal parameters of the active measuring signal and for storing the electrical characteristics of the power supply system (4).

6. The device (2) for insulation monitoring according to any one of claims 1 to 7,
**characterized in that**
the evaluating device (8) has a processing unit (30) for performing digital signal processing algorithms in order to extract a fault current portion that is driven by the active measuring signal from each of the registered differential current measuring signals, the stored signal parameters and electrical characteristics.

7. The device (2) for insulation monitoring according to claim -6,
**characterized in that**
a processing rule is implemented in the processing unit (30) of the evaluating device (8) to determine the total insulation resistance of the power supply system (4) and, optionally, to determine the partial insulation resistances of the main system (14) and of the subsystems (16) on the basis of the extracted fault current portions.

8. The device (2) for insulation monitoring according to any one of claims 1 to 9,
**characterized in that**
for insulation fault location, the evaluating device (8) is configured to locate an insulation fault on the basis of the registered differential currents.

9. The device (2) for insulation monitoring according to any one of claims 1 to 10,
**characterized in that**
the subsystem (16) has an evaluating device that is connected to the differential current measuring device (12) of said subsystem (16) to autarkically evaluate the differential current measuring signal provided by the differential current measuring device (12) of said subsystem (16).

10. The device (2) for insulation monitoring according to any one of claims 1 to 11,
**characterized in that**
the subsystem (16) for voltage measurement against ground (PE) has an artificial neutral point (22).

11. A method for insulation monitoring in a power supply system (4) that is composed of a main system (14) including a neutral point that is high-resistance grounded via a neutral-point resistance (18) or of the main system (14) including the neutral point that is high-resistance grounded via the neutral-point resistance (18) and at least one subsystem (16), wherein a differential current is registered in each of the main system (14) and the subsystem (16) by a differential current measuring device (10, 12),
the method consisting of the following steps:
generation of an active measuring signal and feeding of the active measuring signal into the power supply system (4) by a measuring signal generator (6) and evaluation of differential current measuring signals by an evaluating device (8) that is connected to the differential current measuring devices (10, 12) and to the measuring signal generator (6), a measuring voltage (Uₘₑₛₛ) being injected as the active measuring signal serially to the neutral-point resistance (18) at low resistance as a voltage drop or a measuring current being injected as the active measuring signal in parallel to the neutral-point resistance (18).

12. The method for insulation monitoring according to any one of claims 13 to 15,
**characterized in that**
a voltage signal is tapped against ground (PE) via an artificial neutral point (22) of outer conductors (L1, L2, L3) of the main system (14).

13. The method for insulation monitoring according to any one of claims 13 to 16,
**characterized in that**
the generated active measuring signal is controlled, wherein the active measuring signal appearing in the main system (14) is fed back as the voltage signal that can be tapped via the artificial neutral point (22).

14. The method for insulation monitoring according to any one of claims 13 to 17,
**characterized in that**
the signal shape and the signal parameters of the active measuring signal are adapted to electrical characteristics of the power supply system (4) to be monitored.

15. The method for insulation monitoring according to any one of claims 13 to 18,
**characterized in that**
the signal shape and the signal parameters of the active measuring signal and the electrical characteristics of the power supply system (4) are stored in a data memory (28) of the evaluating device (8).

16. The method for insulation monitoring according to any one of claims 13 to 19,
**characterized in that**
in a processing unit (30) of the evaluating device (8), digital signal processing algorithms are performed that extract a fault current portion driven by the active measuring signal from each of the registered differential current measuring signals and the stored signal parameters und the electrical characteristics.

17. The method for insulation monitoring according to claim 20,
**characterized in that**
in the processing unit (30) of the evaluating device (8), the total insulation resistance of the power supply system (4) and, optionally, the partial insulation resistances of the main system (14) and of the subsystems (16) are determined on the basis of the extracted fault current portions.

18. The method for insulation monitoring according to any one of claims 13 to 21,
**characterized in that**
for insulation fault location, an insulation fault is located in the evaluating device (8) on the basis of the registered differential currents.

19. The method for insulation monitoring according to any one of claims 13 to 22,
**characterized in that**
the differential current measuring signal that is provided by the differential current measuring device (12) of the subsystem (16) is autarkically evaluated by means of an evaluating device in said subsystem (16).

20. The method for insulation monitoring according to any one of claims 13 to 23,
**characterized in that**
a voltage measurement against ground (PE) takes place in the subsystem (16) via an artificial neutral point (22).

## Revendications

1. Dispositif (2) de surveillance d'isolement dans un système d'alimentation électrique (4) qui se compose d'un système principal (14) comprenant un point neutre qui est mis à la terre à haute résistance par une résistance de point neutre (18) ou du système principal (14) comprenant le point neutre qui est mis à la terre à haute résistance par la résistance de point neutre (18) et au moins un sous-système (16), le système principal (14) et le sous-système (16) existant ayant chacun un dispositif de mesure de courant différentiel (10, 12) destiné à détecter un courant différentiel,
le dispositif ayant : un générateur de signal de mesure (6) destiné à générer un signal de mesure actif et à injecter le signal de mesure actif dans le système d'alimentation électrique (4) et par un dispositif d'évaluation (8) qui est connecté aux dispositifs de mesure de courant différentiel (10, 12) et au générateur de signal de mesure (6) afin d'évaluer des signaux de mesure de courant différentiel, le signal de mesure actif étant une tension de mesure (Uₘₑₛₛ) injectée en série avec la résistance de point neutre (18) à basse résistance comme chute de tension ou un courant de mesure qui est injecté en parallèle avec la résistance de point neutre (18).

2. Dispositif (2) de surveillance d'isolement selon l'une quelconque des revendications 1 à 3,
**caractérisé par**
un point neutre (22) artificiel sur les conducteurs extérieurs (L1, L2, L3) du système principal (14), un signal de tension à la terre pouvant être prélevé par ledit point neutre artificiel.

3. Dispositif (2) de surveillance d'isolement selon l'une quelconque des revendications 1 à 3,
**caractérisé en ce que**
le générateur de signal de mesure (6) a une unité de régulation (20) destinée à régler le signal de mesure actif généré, le signal de mesure actif se présentant dans le système principal (14) étant renvoyé comme signal de tension qui peut être prélevé par le point neutre (22) artificiel.

4. Dispositif (2) de surveillance d'isolement selon l'une quelconque des revendications 1 à 5,
**caractérisé en ce**
**qu'**une forme et des paramètres du signal de mesure actif peuvent être adaptés à des caractéristiques électriques du système d'alimentation électrique (4) à surveiller.

5. Dispositif (2) de surveillance d'isolement selon l'une quelconque des revendications 1 à 6,
**caractérisé en ce que**
le dispositif d'évaluation (8) a une mémoire de données (28) pour l'enregistrement de la forme et des paramètres du signal de mesure actif et pour l'enregistrement des caractéristiques électriques du système d'alimentation électrique (4).

6. Dispositif (2) de surveillance d'isolement selon l'une quelconque des revendications 1 à 7,
**caractérisé en ce que**
le dispositif d'évaluation (8) a une unité de traitement (30) destinée à exécuter des algorithmes numériques de traitement de signal afin d'extraire une partie de courant de défaut qui est entraînée par le signal de mesure actif à partir de chacun des signaux de mesure de courant différentiel détectés, des paramètres de signal enregistrés et des caractéristiques électriques.

7. Dispositif (2) de surveillance d'isolement selon la revendication -6,
**caractérisé en ce**
**qu'**une règle de traitement est implémentée dans l'unité de traitement (30) du dispositif d'évaluation (8) pour déterminer la résistance d'isolement totale du système d'alimentation électrique (4) et, facultativement, pour déterminer les résistances d'isolement partielles du système principal (14) et des sous-systèmes (16) sur la base des parties de courant de défaut extraites.

8. Dispositif (2) de surveillance d'isolement selon l'une quelconque des revendications 1 à 9,
**caractérisé en ce que**
pour la localisation de défauts d'isolement, le dispositif d'évaluation (8) est configuré pour localiser un défaut d'isolement sur la base des courants différentiels détectés.

9. Dispositif (2) de surveillance d'isolement selon l'une quelconque des revendications 1 à 10,
**caractérisé en ce que**
le sous-système (16) a un dispositif d'évaluation qui est connecté au dispositif de mesure de courant différentiel (12) dudit sous-système (16) afin d'évaluer de manière autarcique le signal de mesure de courant différentiel fourni par le dispositif de mesure de courant différentiel (12) dudit sous-système (16).

10. Dispositif (2) de surveillance d'isolement selon l'une quelconque des revendications 1 à 11,
**caractérisé en ce que**
le sous-système (16) a un point neutre (22) artificiel pour la mesure de tension à la terre (PE).

11. Procédé de surveillance d'isolement dans un système d'alimentation électrique (4) qui se compose d'un système principal (14) comprenant un point neutre qui est mis à la terre à haute résistance par une résistance de point neutre (18) ou du système principal (14) comprenant le point neutre qui est mis à la terre à haute résistance par la résistance de point neutre (18) et au moins un sous-système (16), un courant différentiel étant détecté dans chacun du système principal (14) et du sous-système (16) existant par un dispositif de mesure de courant différentiel (10, 12),
le procédé comprenant les étapes suivants consistant à :
générer un signal de mesure actif et injecter le signal de mesure actif dans le système d'alimentation électrique (4) par un générateur de signal de mesure (6) et évaluer des signaux de mesure de courant différentiel par un dispositif d'évaluation (8) qui est connecté au dispositif de mesure de courant différentiels (10, 12) et au générateur de signal de mesure (6), une tension de mesure (Uₘₑₛₛ) étant injectée comme signal de mesure actif en série avec la résistance de point neutre (18) à basse résistance comme chute de tension ou un courant de mesure étant injecté comme signal de mesure actif en parallèle avec la résistance de point neutre (18).

12. Procédé de surveillance d'isolement selon l'une quelconque des revendications 13 à 15,
**caractérisé en ce**
**qu'**un signal de tension à la terre (PE) est prélevé par un point neutre (22) artificiel des conducteurs extérieurs (L1, L2, L3) du système principal (14).

13. Procédé de surveillance d'isolement selon l'une quelconque des revendications 13 à 16,
**caractérisé en ce que**
le signal de mesure actif généré est réglé, le signal de mesure actif se présentant dans le système principal (14) étant renvoyé comme signal de tension qui peut être prélevé par le point neutre (22) artificiel.

14. Procédé de surveillance d'isolement selon l'une quelconque des revendications 13 à 17,
**caractérisé en ce que**
la forme et les paramètres du signal de mesure actif sont adaptés aux caractéristiques électriques du système d'alimentation électrique (4) à surveiller.

15. Procédé de surveillance d'isolement selon l'une quelconque des revendications 13 à 18,
**caractérisé en ce que**
la forme et les paramètres du signal de mesure actif et les caractéristiques électriques du système d'alimentation électrique (4) sont enregistrés dans une mémoire de données (28) du dispositif d'évaluation (8).

16. Procédé de surveillance d'isolement selon l'une quelconque des revendications 13 à 19,
**caractérisé en ce que**
des algorithmes numériques de traitement de signal qui extraient une partie de courant de défaut entraînée par le signal de mesure actif à partir de chacun des signaux de mesure de courant différentiel détectés et les paramètres de signal enregistrés et des caractéristiques électriques sont exécutés dans une unité de traitement (30) du dispositif d'évaluation (8).

17. Procédé de surveillance d'isolement selon la revendication 20,
**caractérisé en ce que**
la résistance d'isolement totale du système d'alimentation électrique (4) et, facultativement, les résistances d'isolement partielles du système principal (14) et des sous-systèmes (16) sont déterminées sur la base des parties de courant de défaut extraites dans l'unité de traitement (30) du dispositif d'évaluation (8).

18. Procédé de surveillance d'isolement selon l'une quelconque des revendications 13 à 21,
**caractérisé en ce que**
pour la localisation de défauts d'isolement, un défaut d'isolement est localisé dans le dispositif d'évaluation (8) sur la base des courants différentiels détectés.

19. Procédé de surveillance d'isolement selon l'une quelconque des revendications 13 à 22,
**caractérisé en ce que**
le signal de mesure de courant différentiel qui est fourni par le dispositif de mesure de courant différentiel (12) du sous-système (16) est évalué de manière autarcique par un dispositif d'évaluation dans ledit sous-système (16).

20. Procédé de surveillance d'isolement selon l'une quelconque des revendications 13 à 23,
**caractérisé en ce**
**qu'**une mesure de tension à la terre (PE) s'effectue dans le sous-système (16) par un point neutre (22) artificiel.
